# EUROPÄISCHE PATENTSCHRIFT

(11) **EP 0 667 034 B1**
(45) Veröffentlichungstag und Bekanntmachung des Hinweises auf die Patenterteilung: **14.11.2001**
(21) Anmeldenummer: 94926902.1
(22) Anmeldetag: 29.08.1994
(51) Int. Cl.: H01J 37/34

(54) **MAGNETFELDKATHODE**
MAGNETIC FIELD CATHODE
CATHODE A CHAMP MAGNETIQUE

(30) Priorität: 30.08.1993 DE 4329155
(43) Veröffentlichungstag der Anmeldung: 16.08.1995
(73) Patentinhaber: W. Blösch AG, CH-2540 Grenchen (CH)
(72) Erfinder: CURTINS, Hermann, CH-2540 Grenchen (CH)
(74) Vertreter: EGLI-EUROPEAN PATENT ATTORNEYS
(86) Internationale Anmeldenummer: EP9402849
(87) Internationale Veröffentlichungsnummer: WO9506954

(56) Entgegenhaltungen:
- EP-A- 0 549 854
- DE-A- 3 735 162
- US-A- 4 401 539
- US-A- 4 865 708
- US-A- 4 891 560
- PATENT ABSTRACTS OF JAPAN vol. 7, no. 281 (C-200) (1426) 15. Dezember 1983 & JP,A,58 157 973 (HITACHI SEISAKUSHO K.K.) 20. September 1983

## Beschreibung

Die Erfindung betrifft eine Magnetfeldkathode für Bogenentladungsverdampfer mit einem flächig ausgebildeten Target und einer dem Target zugeordneten, zumindest eine Ringspule und einen Permanentmagneten aufweisenden Anordnung zur Erzeugung eines den Lichtbogen auf der Targetfläche haltenden Magnetfeldes.

Von Magnetfeldkathoden für Bogenentladungsverdampfer, die in der Arc-Beschichtungstechnologie verwendet werden, wird vor allem eine gleichmäßige Target-Erosion, Bogenstabilität, Langzeitstabilität und eine Vermeidung des Auftretens von Target-Vergiftungen während des Betriebs gefordert.

Die in der Praxis besonders kritische Target-Vergiftung tritt in Form dickerer, sogar mit bloßem Auge sichtbarer Beläge an kleineren oder größeren Flächenbereichen des Targets in Erscheinung, wobei im Falle des Auftretens solcher vergifteter Flächenbereiche der sich auf dem Target bewegende Bogen diese Bereiche vermeidet und als Folge davon die Target-Vergiftung durch Ausbildung solch dickerer Beläge, zum Beispiel aus TiN oder TiCN, fortschreitet. Das Auftreten derartiger Target-Vergiftungen ist nicht reproduzierbar und beeinträchtigt die Konstanz der Abscheiderate, die Plasmastabilität sowie die Schicht- und Hafteigenschaften in sehr negativer Weise.

Es wurde bereits versucht, diese Nachteile von Magnetfeldkathoden für Bogenentladungsverdampfer dadurch zu verringern, daß mittels mechanisch bewegter Magnetfeldkonfigurationen oder durch Verwendung zeitlich variabler Magnetfelder der Fußpunkt des Bogens über die Oberfläche des Targets bewegt wurde.

Eine mechanische Bewegung von Magnetfeldkonfigurationen erfordert jedoch einen erheblichen, in der Praxis nicht tragbaren Aufwand und lässt ebenso wie die Verwendung zeitlich variabler Magnetfelder hinsichtlich der erzielbaren Ergebnisse zu wünschen übrig, da mittels dieser Verfahrensweisen keine Langzeitkonstanz, Gleichmässigkeit des Erosionsbildes und keine ausreichende Stabilität des Bogens gewährleistet werden kann und vor allem Target-Vergiftungen bei hochreaktiven Prozessen, wie der Abscheidung von TiCN, nicht ausgeschlossen werden können. Eine Magnetfeldkathode geeignet für Entladungsverdampfer ist aus US-A-4 401 539 bekannt.

Aufgabe der Erfindung ist es daher, die Nachteile bekannter Magnetfeldkathoden zu beseitigen und eine verbesserte Magnetfeldkathode zu schaffen, die trotz eines konstruktiv einfachen Aufbaus den jeweiligen Anforderungen der Praxis optimal anpassbar ist und vor allem eine Konstanz der Abscheiderate, Plasma- und Bogenstabilität sowie eine verbesserte Gleichmässigkeit des Erosionsbildes und die Vermeidung von Target-Vergiftungen gewährleistet.

Diese Aufgabe wird nach der Erfindung und entsprechend den Merkmalen des Anspruches 1 dadurch gelöst, dass eine Magnetfeldkathode für Bogenentladungsverdampfer mit einem flächig ausgebildeten Target und einer dem Target zugeordneten, zumindest eine Ringspule und einen Permanentmagneten aufweisenden Anordnung zur Erzeugung eines den Lichtbogen auf der Target-Fläche haltenden Magnetfeldes vorgeschlagen wird, welche dadurch gekennzeichnet ist, dass eine dem Targetzentrum zugeordnete innenliegende Ringspule (2) und zumindest eine dem Targetumfangsbereich zugeordnete aussenliegende Ringspule (3) vorgesehen sind, dass die innenliegende Ringspule (2) einen im Targetzentrum angeordneten Permanentmagneten (4) umschliesst und zusammen mit diesem Permanentmagneten (4) einen Feldlinienkonzentrator bildet, und dass eine Einrichtung zur Nachregulierung der von den Ringspulen (2, 3) erzeugten Magnetfeldstärken in Abhängigkeit von der Target-Erosion vorgesehen ist, welche die Magnetfeldstärke beim Überschreiten eines vorgebbaren Bogenspannungsanstiegs nachregelt.

Insbesondere für schmale und damit auch kostengünstige Kathoden kann die gestellte Aufgabe auch dadurch gelöst werden, dass dem im Targetzentrum angeordneten, einen Feldlinienkonzentrator bildenden Permanentmagneten nur eine einzige ihn umschliessende Ringspule zugeordnet ist, und dass die Längen- und Breitenabmessungen des Targets zumindest im wesentlichen an den von Ringspule und Permanentmagnet erzeugten Bereich paralleler, im Target verlaufender Feldlinien angepasst sind.

Durch die Ausgestaltung und das Zusammenwirken der magnetfelderzeugenden Komponenten und ihre Positionierung relativ zum Target gelingt es in Verbindung mit einer geeigneten Wahl der Stromstärken und Polaritäten, ein die jeweils gewünschte Stärke besitzendes Magnetfeld zu erzeugen, das praktisch über die gesamte Target-Oberfläche, das heißt von den Randbereichen bis zum Target-Zentrum, einen optimalen Parallelverlauf der Feldlinien aufweist und damit sicherstellt, daß der Fußpunkt des sich ausbildenden Bogens nicht durch vertikale Magnetfeldkomponenten in bestimmten Target-Bereichen unter Ausbildung einer Erosionsspur festgehalten wird.

Es gelingt somit, eine Magnetfeldkathode zu schaffen, die den bestehenden Forderungen nach Wirtschaftlichkeit, Langzeitprozeßstabilität, Bogenstabilität, Freiheit von Vergiftungserscheinungen und Gleichförmigkeit des Target-Abtrags Rechnung trägt.

Die Ringspulen, die in zur Targetebene zumindest im wesentlichen parallelen Ebenen gelegen sind, können unterhalb des Targets in einer gleichen Ebene angeordnet sein, aber es ist auch möglich, die Ringspulen in zueinander versetzten Parallelebenen zu positionieren sowie die Ringspulen relativ zur Targetebene und / oder relativ zueinander verstellbar anzuordnen, da auf diese Weise der Magnetfeldverlauf im Bereich der Targetoberfläche beeinflußbar ist und durch die entsprechende Spulenpositionierung die Ausbildung unerwünschter vertikaler Magnetfeldkomponenten verhindert und deren Vorhandensein im Zentrums- und Randbereich des Targets auf die Targetfläche bezogen minimiert werden kann.

Bevorzugt besteht der zusammen mit der innenliegenden Spule den mittig gelegenen Feldlinienkonzentrator bildende Permanentmagnet aus einem Ferrit, aus Samarium-Kobalt, Neodym-Eisen-Bor, Eisen-Chrom-Kobalt oder Aluminium-Nickel-Kobalt, wodurch es möglich wird, die räumlichen Abmessungen des Permanentmagneten zu minimieren, so daß im Kathodenzentrum eine sehr kompakte Anordnung aus Permanentmagnet und innerer Ringspule erhalten wird, was wiederum sicherstellt, daß die Targetfläche optimal genutzt werden kann.

Im Falle der bevorzugten Verwendung von zwei Ringspulen, nämlich einer inneren Ringspule und einer äußeren Ringspule, sind diese Spulen vorzugsweise gleichartig aufgebaut und aus Kupferdraht gewickelt, aber dies stellt keine Notwendigkeit dar, da die zu erzeugenden Magnetfelder mit zur Target-Oberfläche parallel verlaufenden Feldlinien auch erhalten werden können, wenn beispielsweise die Windungszahlen und / oder Leiterquerschnitte unterschiedlich gewählt sind. Möglich ist es auch, die Ringspulen in Form einer einzigen Leiterwindung auszuführen, wodurch eine besonders kleinvolumige Bauweise erhalten wird, da in diesem Falle die Luftzwischenräume zwischen den einzelnen Windungen einer gewickelten Spule entfallen.

Wesentlich ist, daß jede der beiden Ringspulen unterschiedlich mit Strom beaufschlagbar ist, wozu vorzugsweise jeder Spule eine eigene Stromquelle zugeordnet ist und damit jede Spule so beaufschlagt werden kann, daß durch geeignete Wahl der Stromstärken und Polaritäten die jeweils gewünschte optimale Gesamtkonfiguration des Magnetfeldes erzeugt wird, und zwar unter Berücksichtigung der jeweiligen praktischen Gegebenheiten, wie zum Beispiel der Target-Stärke.

Unter Berücksichtigung der eingestellten Magnetfelder ist jedoch stets darauf zu.achten, daß der Arc-Strom so gewählt wird, daß zwecks Erzielung eines optimalen Erosionsbildes und zwecks Vermeidung von Target-Vergiftungen die sich auf der Targetfläche ergebenden Spuren des sich in einer vorgebbaren Umlaufrichtung bewegenden Bogens ständig zwischen sich verzweigenden Haupt- und Nebenästen wechseln, wobei im Verlauf dieser Bogenfußpunktbewegung Nebenäste zu Hauptästen werden und umgekehrt.

In diesem Zusammenhang ist es im Rahmen der Erfindung auch von wesentlicher Bedeutung, daß die Bogenspannung bzw. die Magnetfeldstärke definiert vorgegeben wird, wobei vorzugsweise jedem Schichttyp eine charakteristische Magnetfeldstärke zuzuordnen ist.

Eine weitere Besonderheit besteht darin, daß eine Nachregulierung der von den Ringspulen erzeugten Magnetfeldstärken in Abhängigkeit von der jeweiligen Target-Erosion erfolgt, wobei eine Nachregulierung insbesondere dann vorgenommen wird, wenn sich ein bestimmter, auch in Abhängigkeit vom Schichttyp vorgebbarer Bogenspannungsanstieg einstellt.

An der Unterseite des Targets kann gemäß der Erfindung eine Ausnehmung zur Aufnahme des Permanentmagneten vorgesehen sein, was insbesondere im Falle der Verwendung dickerer Targets von Vorteil ist. Diese Ausnehmung an der Unterseite des Targets befindet sich im nicht erodierten Zentralbereich des Targets und führt daher zu keiner Beeinträchtigung der Targetausnutzung, vielmehr ergibt sich aufgrund der Annäherung des Permanentmagneten an die Targetoberfläche gerade bei dickeren Targets ein positiver Target-Ausnutzeffekt.

Wenn gemäß einer weiteren Ausgestaltung der Erfindung die außenliegende Ringspule nicht unterhalb, sondern seitlich außerhalb des Targets angeordnet wird, dann läßt sich auf diese Weise die Targetausnutzung weiter verbessern, da der Erosionsbereich bis unmittelbar zum jeweiligen Targetrand erstreckt werden kann.

Es ist auch möglich, die Magnetfeldkathode nach der Erfindung nach der Art eines unbalancierten Magnetrons zu betreiben, wobei in diesem Falle zumindest eine weitere, die Magnetfeldkathode und ihre zugehörigen Ringspulen umschließende Magnetspule vorgesehen wird, welche so betrieben wird, daß ein die Plasmaausbreitung in den Raum vor der Kathode förderndes Magnetfeld entsteht, wobei durch Abstimmung der durch die erfindungsgemäß vorgesehenen innen- und außenliegenden Ringmagnetspulen auch bei dieser Ausgestaltung sichergestellt werden kann, daß im Bereich des Targets ein zu dessen Oberfläche paralleler Magnetfeldverlauf gewährleistet ist.

Weitere besonders vorteilhafte Ausgestaltungen und Merkmale der Erfindung sind in Unteransprüchen angegeben.

Ausführungsbeispiele der Erfindung werden nachfolgend unter Bezugnahme auf die Zeichnung erläutert; in der Zeichnung zeigt:
- Figur 1: eine schematische Darstellung des Aufbaus einer Magnetfeldkathode nach der Erfindung,
- Figur 2: ein typisches Erosionsbild eines Targets der Magnetfeldkathode nach Figur 1,
- Figur 3: eine schematische Darstellung einer Ausführungsform der Magnetfeldkathode nach Figur 1 mit in das Target integriertem Permanentmagneten,
- Figur 4: eine schematische Darstellung einer weiteren Ausführungsvariante der erfindungsgemäßen Magnetfeldkathode, und
- Figur 5: eine schematische Darstellung einer für schmale Kathoden geeigneten weiteren Ausführungsvariante der Magnetfeldkathode nach der Erfindung.

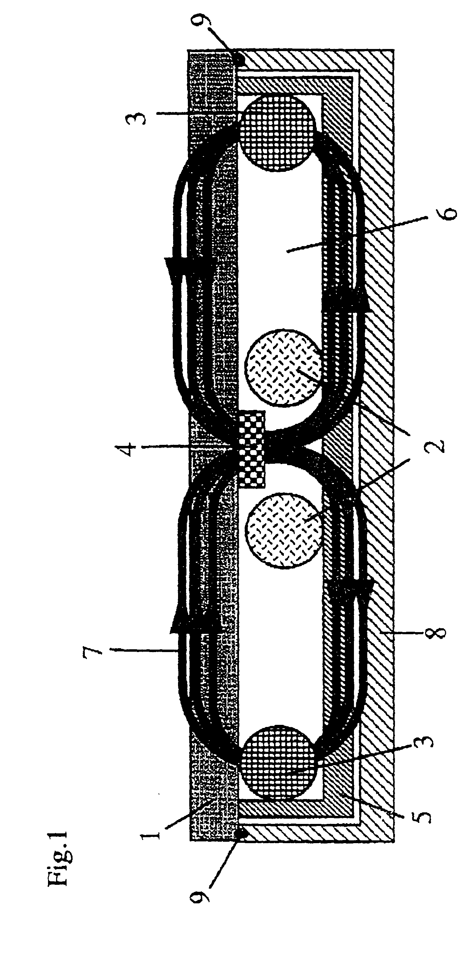

Figur 1 zeigt ein Target 1, bei dem es sich beispielsweise um ein Ti-Target handeln kann, welches welches in der Draufsicht die Form eines langgestreckten Rechtecks besitzt.

Diesem Target 1 zugeordnet ist eine magnetfelderzeugende Anordnung, bestehend aus einer innenliegenden Spule 2, einer außenliegenden Spule 3 und einem zentral angeordneten Permanentmagneten 4.

Die beiden Spulen 2, 3 sind in ihrer Form der Target-Form angepaßt und erstrecken sich im wesentlichen über die gesamte Target-Länge, wobei zwischen den beiden sich in Target-Längsrichtung erstreckenden Schenkeln der Innenspule 2 ein Aufnahmebereich für den Permanentmagneten 4 vorgesehen ist.

Der Permanentmagnet 4 besitzt Stabform und ist möglichst schmal ausgeführt, so daß im Zentrumsbereich des Targets 1 die Innenspule 2 und der Permanentmagnet 4 möglichst dicht aneinanderliegend angeordnet werden können.

Bevorzugt werden für den Permanentmagneten solche Magnetmaterialien verwendet, die geeignet sind, bei kleinem Volumen ein starkes Magnetfeld zu erzeugen, und dazu eignen sich vorzugsweise Magnete aus Ferrit, Samarium-Kobalt, Neodym-Eisen-Bor, Eisen-Chrom-Kobalt oder Aluminium-Nickel-Kobalt.

Die beiden Spulen 2, 3 und der Permanentmagnet 4 sind in einem Gehäuse 5 angeordnet, das vorzugsweise aus Kunststoffmaterial besteht und flachwannenförmig ausgebildet ist. Der Innenraum 6 dieses Gehäuses 5 bildet gleichzeitig einen Kühlmittelraum, das heißt es kann durch das Gehäuse 5, dessen Deckenwand von dem Target 1 gebildet sein kann, Kühlmittel geleitet werden.

Das die beiden Spulen (2, 3) aufnehmende Kunststoffgehäuse (5) befindet sich innerhalb einer metallischen, zum Beispiel aus Kupfer, Edelstahl und dergleichen bestehenden Wanne (8), die deckseitig offen ausgebildet ist und als Targetträger dient. Zwischen der metallischen Wanne (8) und dem Target (1) ist eine Vakuumdichtung (9) vorgesehen.

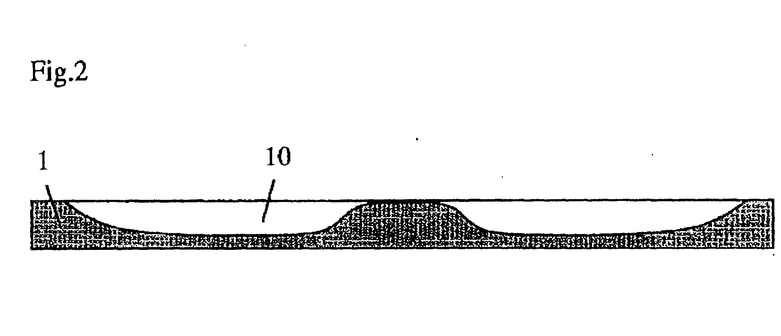

Figur 2 zeigt ein typisches Erosionsbild, wie es bei Verwendung einer Magnetfeldkathode nach Figur 1 erhalten werden kann. Dieses Erosionsbild verdeutlicht, daß sich der Erosionsbereich 10 zwischen dem Target-Zentralbereich und dem Target-Randbereich in ausgesprochen gleichmäßiger Weise erstreckt, das heißt es liegt eine sehr gute Targetausnutzung vor.

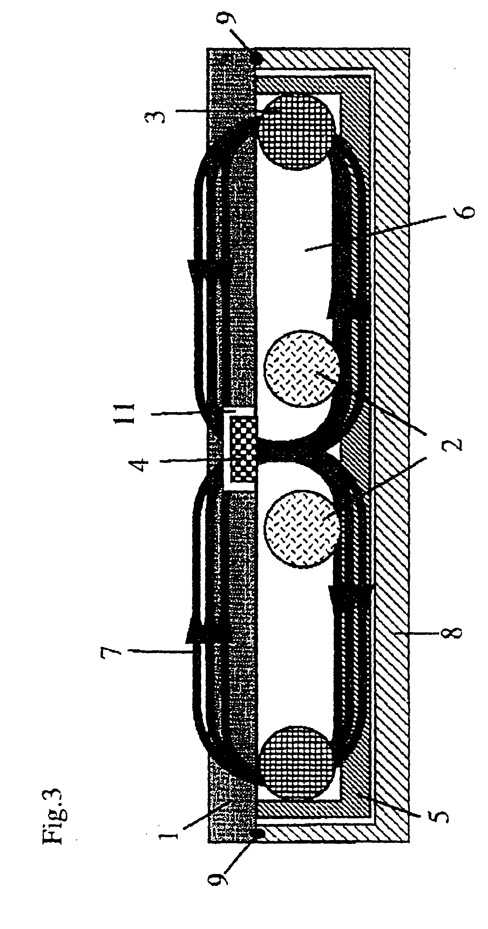

Die Ausführungsform nach Figur 3 unterscheidet sich von der Ausführungsform einer Magnetfeldkathode nach Figur 1 dadurch, daß an der Unterseite des Targets 1 in dessen Zentralbereich eine Ausnehmung 11 zur Aufnahme des Permanentmagneten 4 vorgesehen ist. Diese Ausnehmung 11 kann so gestaltet sein, daß der Permanentmagnet 4 mit geringem Spiel oder formschlüssig in der Ausnehmung 11 gehaltert ist, wobei der Permanentmagnet 4 ganz oder teilweise in dieser Ausnehmung 11 aufgenommen sein kann.

Diese Ausführungsform eignet sich vor allem für dickere Targets 1, wobei zum einen der Parallelverlauf der Magnetfeldlinien 7 bis in das Targetzentrum auch bei diesen dickeren Targets gefördert wird und zum anderen dazu gerade derjenige Targetbereich genutzt wird, der - wie Figur 2 zeigt - praktisch nicht erodiert wird.

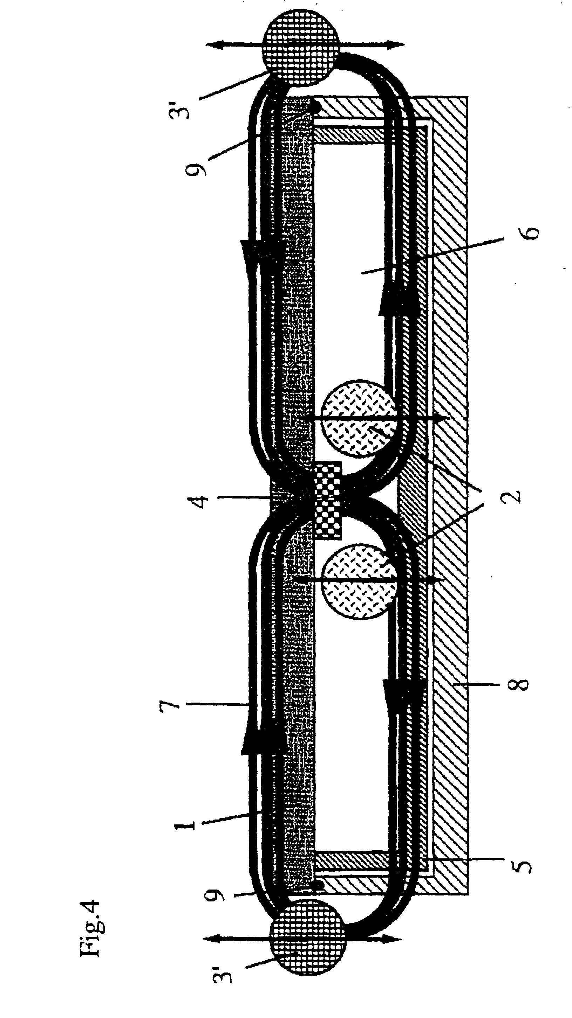

Die Ausführungsform nach Figur 4 verdeutlicht, daß die außenliegende Ringspule 3' auch außerhalb des Targets 1 angeordnet sein kann, und daß die innenliegende Ringspule 2 ebenso wie die außenliegende Ringspule 3' relativ zueinander und auch relativ zum Target 1 verstellt werden können, das heißt daß durch Vorgabe der Position der durch die Ringspulen 2 und 3' bestimmten Ebenen relativ zueinander und zur Targetebene die erzeugten Magnetfelder so vorgegeben und beeinflußt werden können, daß im Zusammenwirken mit dem Permanentmagneten 4 praktisch über die gesamte Targetoberfläche ein Parallelverlauf der Magnetfeldlinien 7 erzielt werden kann, und zwar bei den unterschiedlichsten Arten von Targets und auch während des sich im Betrieb ergebenden Targetabbaus.

Die Verstellmöglichkeit der innenliegenden Spule 2 und der außenliegenden Spule 3' ist in Figur 4 durch Doppelpfeile gekennzeichnet.

Um zwischen der außenliegenden Ringspule 3' und dem Target 1 einen möglichst guten Flußübergang zu gewährleisten, kann gegebenenfalls eine Ankopplung dieser außenliegenden Ringspule 3' über eine Weicheisenlage erfolgen.

Der Figur 4 ist auch deutlich zu entnehmen, daß mittels einer außerhalb des Targets 1 liegenden Ringspule 3' eine vorteilhafte Ausdehnung des Erosionsbereichs des Targets 1 bis zu dessen Rand ermöglicht wird, was gegenüber dem in Figur 2 gezeigten Erosionsbild eine weitere Verbesserung darstellt.

Selbstverständlich kann auch bei der Magnetfeldkathode nach Figur 4 der Permanentmagnet 4 analog zur Ausführungsform nach Figur 3 in einer Targetausnehmung ganz oder teilweise aufgenommen sein.

Durch geeignete Wahl der Stromstärken in den beiden Spulen 2, 3 gelingt es in Verbindung mit der speziellen Positionierung des kompakt ausgeführten und speziell positionierten Permanentmagneten 4, ein zum jeweiligen Schichttyp passendes, die gewünschte Stärke besitzendes Magnetfeld mit nahezu zur gesamten Target-Oberfläche parallel verlaufenden Feldlinien zu erzeugen, und zwar sowohl bei dicken als auch bei dünnen Targets, das heißt auch bei fortgeschrittener Erosion.

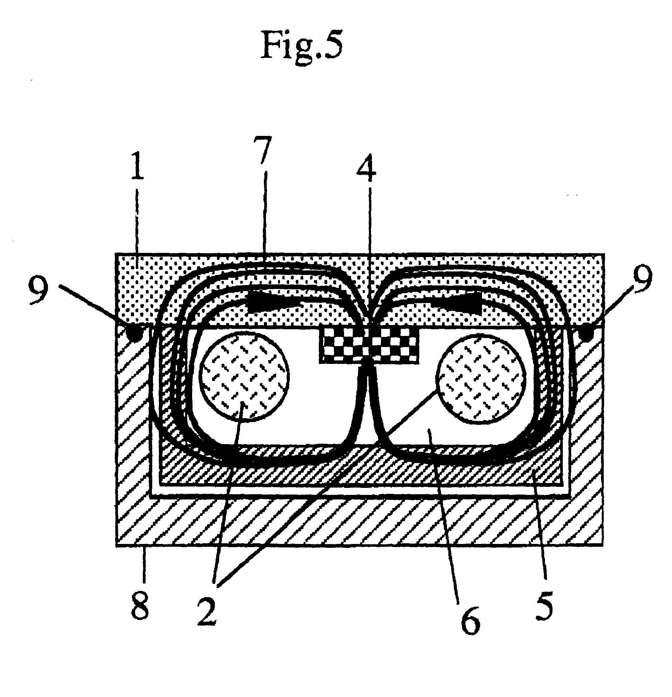

Figur 5 zeigt eine Ausführungsform der Erfindung, die insbesondere für schmale Kathoden bestimmt und besonders preiswert gestaltet ist. Dabei besteht die magnetfelderzeugende Anordnung aus einer einzigen Spule 2, die dem zentral angeordneten Permanentmagneten 4 benachbart ist und diesen umschließt. Durch das Zusammenwirken der Spule 2 und des wiederum einen Magnetfeldkonzentrator bildenden Permanentmagneten 4 werden im Target 1 Parallel-Feldlinien 7 erzeugt, deren flächige Erstreckung zumindest im wesentlichen die Targetabmessungen bestimmt. Es wird auf diese Weise auch bei derartigen schmalen und preisgünstigen Targets sichergestellt, daß auch alle im Zusammenhang mit den vorstehenden Ausführungen erläuterten Vorteile erhalten werden, wobei die im Zusammenhang mit den Ausführungsvarianten mit innenliegender und außenliegender Spule beschriebenen Modifikationen in analoger Weise auch bei diesem schmalen Target anwendbar sind.

Durch die erzielte Magnetfeldkonfiguration ist in Verbindung mit der gewählten Bogenstromstärke sichergestellt, daß der Fußpunkt des Bogens stets in Bewegung ist und sich nicht an irgendwelchen Bereichen des Targets einfrißt und zu störenden Erosionsspuren sowie zur unerwünschten Bildung größerer Tropfen führt, die herausgeschleudert werden könnten und die Schichtqualität wesentlich verschlechtern würden.

Durch die erfindungsgemäße Ausgestaltung des Targets ist es nicht nur möglich, eine überraschend gute und sich im wesentlichen über die gesamte Target-Fläche erstreckende Magnetfeldparallelität zu gewährleisten, sondern es ist auch möglich, die Stärke des Magnetfeldes flexibel, und zwar über die gesamte Lebensdauer des Targets flexibel einzustellen.

Die sich aus Aufbau und Funktion der Magnetfeldkathode nach der Erfindung ergebenden Vorteile bestehen vor allem darin,
daß eine optimale und gleichförmige Erosion und damit eine bestmögliche Ausnützung des jeweiligen Targets gewährleistet werden kann,
daß in Abhängigkeit von der jeweiligen Art der Hartstoffschicht, zum Beispiel TiN, TiCN oder CrN und dergleichen, eine flexible Einstellung der jeweiligen Magnetfeldstärke erfolgen kann,
daß aufgrund des geschaffenen konstanten Parallel-Magnetfelds Vergiftungen des Targets ausgeschlossen werden können und damit eine Konstanz der Qualität über die gesamte Lebensdauer des Targets und als Folge davon auch eine Langzeitprozeßstabilität erreichbar ist,
daß durch die Ausschaltung von Target-Vergiftungen insbesondere auch die Möglichkeit der sequenziellen Abscheidung von Titan-basierten Materialien geschaffen wird, und
daß aufgrund des einfachen Aufbaus praktisch keine Wartungskosten entstehen und damit eine hohe Wirtschaftlichkeit gegeben ist, die auch dadurch zum Ausdruck kommt, daß mittels eines einzigen Targets eine sehr hohe Anzahl von Chargen beschichtet werden kann, zum Beispiel bei einem Target mit einer Stärke von etwa 25 mm bis zu fünfhundert Chargen.

## Patentansprüche

1. Magnetfeldkathode für Bogenentladungsverdampfer mit einem flächig ausgebildeten Target und einer dem Target zugeordneten, zumindest eine Ringspule und einen Permanentmagneten aufweisenden Anordnung zur Erzeugung eines den Lichtbogen auf der Target-Fläche haltenden Magnetfeldes,
**dadurch gekennzeichnet,**
**dass** eine dem Targetzentrum zugeordnete innenliegende Ringspule (2) und zumindest eine dem Targetumfangsbereich zugeordnete aussenliegende Ringspule (3) vorgesehen sind,
**dass** die innenliegende Ringspule (2) einen im Targetzentrum angeordneten Permanentmagneten (4) umschliesst und zusammen mit diesem Permanentmagneten (4) einen Feldlinienkonzentrator bildet, und
**dass** eine Einrichtung zur Nachregulierung der von den Ringspulen (2, 3) erzeugten Magnetfeldstärken in Abhängigkeit von der Target-Erosion vorgesehen ist, welche die Magnetfeldstärke beim Überschreiten eines vorgebbaren Bogenspannungsanstiegs nachregelt.

2. Magnetfeldkathode nach Anspruch 1, **dadurch gekennzeichnet, dass** die Ringspulen (2, 3) in zur Targetebene zumindest im wesentlichen parallelen Ebenen gelegen sind.

3. Magnetfeldkathode nach Anspruch 1 oder 2, **dadurch gekennzeichnet, dass** die Ringspulen (2, 3) zumindest im wesentlichen in einer unterhalb des Targets (1) gelegenen und zumindest im wesentlichen parallel zum Target (1) verlaufenden Ebene angeordnet sind.

4. Magnetfeldkathode nach einem der vorhergehenden Ansprüche, **dadurch gekennzeichnet, dass** zumindest eine der Ringspulen (2, 3) relativ zur Targetebene verstellbar angeordnet ist.

5. Magnetfeldkathode nach einem der vorhergehenden Ansprüche, **dadurch gekennzeichnet, dass** die in zumindest im wesentlichen parallel zum Target (1) verlaufenden Ebenen angeordneten Ringspulen (2, 3) senkrecht zur Targetebene relativ zueinander verstellbar sind.

6. Magnetfeldkathode nach einem der vorhergehenden Ansprüche, **dadurch gekennzeichnet, dass** die innenliegende Ringspule (2) den Permanentmagneten (4) allseitig mit geringem Abstand umschliesst.

7. Magnetfeldkathode nach einem oder mehreren der vorhergehenden Ansprüche, **dadurch gekennzeichnet, dass** die aussenliegende Ringspule (3) unterhalb des Randbereichs des Targets (1) angeordnet ist.

8. Magnetfeldkathode nach einem oder mehreren der vorhergehenden Ansprüche, **dadurch gekennzeichnet, dass** die aussenliegende Ringspule (3) ausserhalb des Targets (1) angeordnet ist.

9. Magnetfeldkathode nach Anspruch 1, **dadurch gekennzeichnet, dass** der Permanentmagnet (4) angrenzend an die Target-Unterseite angeordnet und bezüglich seiner Abmessung in Target-Querrichtung minimiert ist.

10. Magnetfeldkathode nach einem der vorhergehenden Ansprüche, **dadurch gekennzeichnet, dass** der Permanentmagnet (4) in einer in der Targetunterseite vorgesehenen Ausnehmung (11) angeordnet ist.

11. Magnetfeldkathode nach einem der vorhergehenden Ansprüche, **dadurch gekennzeichnet, dass** der Permanentmagnet (4) aus einem Ferrit, aus Samarium-Kobalt (SmCo), Neodym-Eisen-Bor (NdFeB), Eisen-Chrom-Kobalt (FeCrCo) oder Aluminium-Nickel-Kobalt (AlNiCo) besteht.

12. Magnetfeldkathode nach einem der vorhergehenden Ansprüche, **dadurch gekennzeichnet, dass** die senkrecht zur Target-Ebene gelegene Querschnittsfläche des Permanentmagneten (4) kleiner ist als die entsprechende stromleitende Querschnittsfläche der ihn umschliessenden inneren Ringspule (2).

13. Magnetfeldkathode nach einem oder mehreren der vorhergehenden Ansprüche, **dadurch gekennzeichnet, dass** das Target (1) in Form eines langgestreckten Rechtecks ausgebildet ist, die Ringspulen (2, 3) im wesentlichen entsprechend der Umfangskontur des Targets (1) verlaufen und der Permanentmagnet (4) Stabform besitzt, wobei vorzugsweise die Querabmessung des stabförmigen Permanentmagneten (4) im wesentlichen dem gegenseitigen Abstand der Längsabschnitte der innenliegenden Ringspule (2) entspricht.

14. Magnetfeldkathode nach einem oder mehreren der vorhergehenden Ansprüche, **dadurch gekennzeichnet, dass** die beiden Ringspulen (2, 3) zumindest im wesentlichen gleich aufgebaut sind und im wesentlichen gleiche elektrische Eigenschaften besitzen.

15. Magnetfeldkathode nach einem der vorhergehenden Ansprüche, **dadurch gekennzeichnet, dass** jeder Spule (2, 3) eine eigene Stromquelle zugeordnet ist und die Magnetfeldstärken der Spulen unabhängig von einander einstellbar sind.

16. Magnetfeldkathode nach einem oder mehreren der vorhergehenden Ansprüche, **dadurch gekennzeichnet, dass** die Ringspulen (2, 3) sowie der Permanentmagnet (4) in einem gemeinsamen Trägergehäuse (5) angeordnet sind, an dessen Deckwand das Target (1) angrenzt oder dessen Deckwand unmittelbar vom Target (1) gebildet ist, wobei das Trägergehäuse (5) insbesondere flachenwannenförmig und zur Durchleitung von Kühlmittel ausgebildet ist.

17. Magnetfeldkathode nach Anspruch 16, **dadurch gekennzeichnet, dass** das Trägergehäuse (5) aus Kunststoffmaterial besteht und in einer deckseitig offenen metallischen Wanne (8) angeordnet ist, die abdichtend im Aussenrandbereich der Targetunterseite anliegt.

18. Magnetfeldkathode, nach einem der vorhergehenden Ansprüche, **dadurch gekennzeichnet, dass** dem im Targetzentrum angeordneten, einen Feldlinienkonzentrator bildenden Permanentmagneten (4) nur eine einzige ihn umschliessende Ringspule (2) zugeordnet ist, und dass die Längen- und Breitenabmessungen des Targets (1) im wesentlichen an den von Ringspulen (2) und Permanentmagnet (4) erzeugten Bereich paralleler, im Target (1) verlaufender Feldlinien (7) angepasst sind.

19. Verfahren zum Betreiben einer Magnetfeldkathode nach einem oder mehreren der Ansprüche 1 bis 18, **dadurch gekennzeichnet, dass** der Zeitpunkt einer Nachregulierung der von den Ringspulen (2, 3) erzeugten Magnetfeldstärken in Abhängigkeit vom Überschreiten eines vorgebbaren Bogenspannungsanstiegs im Bereich von mehr als 0,3 V bis 0,5 V gewählt wird.

20. Verfahren zum Betreiben einer Magnetfeldkathode nach einem oder mehreren der Ansprüche 1 bis 18, **dadurch gekennzeichnet, dass** bei vorgegebener Magnetfeldstärke der Arc-Strom derart gewählt wird, dass die sich auf der Target-fläche ergebenden Spuren des sich in einer Umlaufrichtung bewegenden Bogenfusspunktes ständig zwischen sich verzweigenden Haupt- und Nebenspuren wechseln und dabei Nebenspuren zu Hauptspuren werden und umgekehrt.

## Claims

1. Magnetic field cathode for arc discharge vaporizers having an areally formed target and an arrangement, which is associated with the target and has at least one ring coil and a permanent magnet, for generating a magnetic field which holds the arc on the target surface, **characterized in that** an inwardly disposed ring coil (2), which is associated with the centre of the target, and at least one outwardly disposed ring coil (3), which is associated with the peripheral region of the target, are provided, and **in that** the inwardly disposed ring coil (2) surrounds a permanent magnet (4) arranged at the centre of the target and, together with this permanent magnet (4), forms a field line concentrator, and **in that** a device for readjustment of the magnetic field strengths generated by the ring coils (2, 3) as a function of the target erosion is provided, which device readjusts the magnetic field strength in the event of a predeterminable arc voltage rise being exceeded.

2. Magnetic field cathode according to Claim 1, **characterized in that** the ring coils (2, 3) are disposed in planes which are at least substantially parallel to the plane of the target.

3. Magnetic field cathode according to Claim 1 or 2, **characterized in that** the ring coils (2, 3) are at least substantially arranged in a plane which lies beneath the target (1) and extends at least substantially parallel to the target (1).

4. Magnetic field cathode according to one of the preceding claims, **characterized in that** at least one of the ring coils (2, 3) is arranged adjustably relative to the plane of the target.

5. Magnetic field cathode according to one of the preceding claims, **characterized in that** the ring coils (2, 3), which are arranged in planes which extend at least substantially parallel to the target (1), are adjustable relative to one another at right angles to the plane of the target.

6. Magnetic field cathode according to one of the preceding claims, **characterized in that** the inwardly disposed ring coil (2) surrounds the permanent magnet (4) on all sides with a small spacing.

7. Magnetic field cathode according to one or more of the preceding claims, **characterized in that** the outwardly disposed ring coil (3) is arranged beneath the edge region of the target (1).

8. Magnetic field cathode according to one or more of the preceding claims, **characterized in that** the outwardly disposed ring coil (3) is arranged outside the target (1).

9. Magnetic field cathode according to Claim 1, **characterized in that** the permanent magnet (4) is arranged bordering on the lower side of the target and is minimized with respect to its dimension in a transverse direction of the target.

10. Magnetic field cathode according to one of the preceding claims, **characterized in that** the permanent magnet (4) is arranged in a recess (11) provided in the lower side of the target.

11. Magnetic field cathode according to one of the preceding claims, **characterized in that** the permanent magnet (4) comprises a ferrite, samarium-cobalt (SmCo), neodymium-iron-boron (NdFeB), iron-chromium-cobalt (FeCrCo) or aluminium-nickel-cobalt (AlNiCo).

12. Magnetic field cathode according to one of the preceding claims, **characterized in that** the cross-sectional area of the permanent magnet (4) perpendicular to the target plane is smaller than the corresponding current-conducting cross-sectional area of the inner ring coil (2) surrounding it.

13. Magnetic field cathode according to one or more of the preceding claims, **characterized in that** the target (1) is formed in the shape of an elongated rectangle, the ring coils (2, 3) extend substantially in accordance with the peripheral contour of the target (1) and the permanent magnet (4) is of bar shape, with the transverse dimension of the bar-like permanent magnet (4) preferably substantially corresponding to the mutual spacing of the longitudinal sections of the inwardly disposed ring coil (2).

14. Magnetic field cathode according to one or more of the preceding claims, **characterized in that** the two ring coils (2, 3) are at least substantially similarly constructed and have substantially the same electrical characteristics.

15. Magnetic field cathode according to one of the preceding claims, **characterized in that** a dedicated power source is assigned to each coil (2, 3), and the magnetic field strengths of the coils can be set independently of one another.

16. Magnetic field cathode according to one or more of the preceding claims, **characterized in that** the ring coils (2, 3) and also the permanent magnet (4) are arranged in a common support housing (5) with the target (1) adjoining its cover wall or with its cover wall being directly formed by the target (1), the support housing (5) being in particular in the form of a flat trough and being designed for coolant to pass through it.

17. Magnetic field cathode according to Claim 16, **characterized in that** the support housing (5) consists of plastic material and is arranged in a metallic trough (8) which is open at the cover side and is in sealed contact with the outer edge region of the lower side of the target.

18. Magnetic field cathode according to one of the preceding claims, **characterized in that** only a single ring coil (2) surrounding the permanent magnet (4) is associated with the permanent magnet (4) which is arranged in the centre of the target and forms a field line concentrator, and **in that** the length and width dimensions of the target (1) are substantially matched to the region of parallel field lines (7), extending in the target (1), which is generated by the ring coils (2) and permanent magnet (4).

19. Method for operating a magnetic field cathode according to one or more of Claims 1 to 18, **characterized in that** the time of a readjustment of the magnetic field strengths generated by the ring coils (2, 3) is selected as a function of a predeterminable arc voltage rise in the region of more than 0.3 V to 0.5 V being exceeded.

20. Method for operating a magnetic field cathode according to one or more of Claims 1 to 18, **characterized in that**, at a predetermined magnetic field strength, the arc current is selected in such a manner that the traces of the arc root moving in a direction of rotation which are produced on the surface of the target change continuously between branching main traces and secondary traces, with secondary traces becoming main traces and vice versa.

## Revendications

1. Cathode de champ magnétique pour des évaporateurs de décharge en arc, comprenant une cible de configuration plate et un agencement attribué à la cible, présentant au moins une bobine toroïdale et un aimant permanent, pour générer un champ magnétique qui maintient l'arc électrique sur la surface de la cible, **caractérisée en ce qu'**on prévoit une bobine toroïdale interne (2) attribuée au centre de la cible et au moins une bobine toroïdale externe (3) attribuée à la périphérie de la cible, **en ce que** la bobine toroïdale interne (2) renferme un aimant permanent (4) disposé au centre de la cible et forme de manière conjointe avec cet aimant permanent (4) un concentrateur de lignes de forces du champ magnétique, et **en ce qu'**on prévoit un mécanisme pour le rajustage des intensités du champ magnétique générées par les bobines toroïdales (2, 3) en fonction de l'érosion de la cible, qui met en oeuvre un rajustage des intensités du champ magnétique lors du dépassement d'une augmentation prédéfinissable de la chute dans l'arc.

2. Cathode de champ magnétique selon la revendication 1, **caractérisée en ce que** les bobines toroïdales (2, 3) sont disposées dans des plans au moins essentiellement parallèles au plan de la cible.

3. Cathode de champ magnétique selon la revendication 1 ou 2, **caractérisée en ce que** les bobines toroïdales (2, 3) sont disposées au moins essentiellement dans un plan situé en dessous de la cible (1) et s'étendant dans une position au moins essentiellement parallèle au plan de la cible (1).

4. Cathode de champ magnétique selon l'une quelconque des revendications précédentes, **caractérisée en ce qu'**au moins une des bobines toroïdales (2, 3) est disposée de manière à pouvoir se déplacer par rapport au plan de la cible.

5. Cathode de champ magnétique selon l'une quelconque des revendications précédentes, **caractérisée en ce que** les bobines toroïdales (2, 3) disposées dans des plans s'étendant au moins essentiellement dans une position parallèle à la cible (1) peuvent se déplacer l'une par rapport à l'autre perpendiculairement au plan de la cible.

6. Cathode de champ magnétique selon l'une quelconque des revendications précédentes, **caractérisée en ce que** la bobine toroïdale interne (2) entoure l'aimant permanent (4) de tous côtés à une petite distance de ce dernier.

7. Cathode de champ magnétique selon l'une quelconque des revendications précédentes, **caractérisée en ce que** la bobine toroïdale externe (3) est disposée en dessous de la zone marginale de la cible (1).

8. Cathode de champ magnétique selon l'une quelconque des revendications précédentes, **caractérisée en ce que** la bobine toroïdale externe (3) est disposée à l'extérieur de la cible (1).

9. Cathode de champ magnétique selon la revendication 1, **caractérisée en ce que** l'aimant permanent (4) est disposé en position limitrophe au côté inférieur de la cible et présente une mesure minimale en ce qui concerne sa dimension dans la direction transversale de la cible.

10. Cathode de champ magnétique selon l'une quelconque des revendications précédentes, **caractérisée en ce que** l'aimant permanent (4) est disposé dans un évidement (11) prévu dans le côté inférieur de la cible.

11. Cathode de champ magnétique selon l'une quelconque des revendications précédentes, **caractérisée en ce que** l'aimant permanent (4) est constitué par une ferrite, par du samarium-cobalt (SmCo), par du néodyme-fer-bore (NdFeB), par du fer-chrome-cobalt (FeCrCo) ou par de l'aluminium-nickel-cobalt (AlNiCo).

12. Cathode de champ magnétique selon l'une quelconque des revendications précédentes, **caractérisée en ce que** la surface en section transversale de l'aimant permanent (4) disposée perpendiculairement au plan de la cible est inférieure à la surface électro-conductrice correspondante en section transversale de la bobine toroïdale interne (2) qui l'entoure.

13. Cathode de champ magnétique selon l'une quelconque des revendications précédentes, **caractérisée en ce que** la cible (1) est réalisée sous la forme d'un rectangle étiré en longueur, les bobines toroïdales (2, 3) s'étendent en épousant essentiellement le contour périphérique de la cible (1) et l'aimant permanent (4) possède la forme d'une barre, dans laquelle, de préférence, la dimension en section transversale de l'aimant permanent (4) en forme de barre correspond essentiellement à l'écartement réciproque des sections longitudinales de la bobine toroïdale interne (2).

14. Cathode de champ magnétique selon l'une quelconque des revendications précédentes, **caractérisée en ce que** les deux bobines toroïdales (2, 3) sont réalisées de manière au moins essentiellement égale et possèdent des propriétés électriques essentiellement égales.

15. Cathode de champ magnétique selon l'une quelconque des revendications précédentes, **caractérisée en ce qu'**une source de courant propre est attribuée à chaque bobine toroïdale (2, 3) et les intensités du champ magnétique des bobines peuvent être réglées de manière réciproquement indépendante.

16. Cathode de champ magnétique selon l'une quelconque des revendications précédentes, **caractérisée en ce que** les bobines toroïdales (2, 3) ainsi que l'aimant permanent (4) sont disposées dans un boîtier de support commun (5), en position limitrophe à la paroi de recouvrement duquel est disposée la cible (1) ou dont la paroi de recouvrement est réalisée directement par la cible (1), dans laquelle le boîtier de support (5) est réalisé en particulier en forme de cuve plate et pour le passage d'un réfrigérant.

17. Cathode de champ magnétique selon la revendication 16, **caractérisée en ce que** le boîtier de support (5) est constitué d'une matière synthétique et est disposé dans une cuve métallique (8) ouverte du côté supérieur qui vient se disposer de manière étanche dans la zone marginale externe du côté inférieur de la cible.

18. Cathode de champ magnétique selon l'une quelconque des revendications précédentes, **caractérisée en ce qu'**à l'aimant permanent (4) disposé au centre de la cible et formant un concentrateur de lignes de forces du champ magnétique, n'est attribuée qu'à une seule bobine toroïdale (2) qui l'entoure, et **en ce que** les dimensions de la cible (1) en longueur et en largeur sont adaptées essentiellement à la zone de lignes de forces (7) parallèles du champ magnétique s'étendant dans la cible (1), générée par la bobine toroïdale (2) et par l'aimant permanent (4).

19. Procédé pour la mise en service d'une cathode de champ magnétique selon une ou plusieurs des revendications 1 à 18, **caractérisé en ce qu'**on sélectionne le moment correspondant à un rajustage des intensités du champ magnétique générées par les bobines toroïdales (2, 3) en fonction du dépassement d'une augmentation prédéfinissable de la chute dans l'arc, dans le domaine allant d'une valeur supérieure de 0,3 V à 0,5 V.

20. Procédé pour la mise en service d'une cathode de champ magnétique selon une ou plusieurs des revendications 1 à 18, **caractérisé en ce que**, dans le cadre d'une intensité de champ magnétique prédéfinie, on sélectionne le courant d'arc de telle sorte que les pistes obtenues à la surface de la cible, de la racine de l'arc se déplaçant dans la direction périphérique alternent constamment entre des pistes principales et des pistes secondaires qui se ramifient, si bien que des pistes secondaires deviennent des pistes principales et inversement.
